Europäisches Patentamt

European Patent Office

Office européen des brevets

(11) Veröffentlichungsnummer: **0 413 320 A2**

## (12) EUROPÄISCHE PATENTANMELDUNG

(21) Anmeldenummer: 90115614.1

(22) Anmeldetag: **14.08.90**

(51) Int. Cl.5: **H01S 3/105**, H01S 3/025

(30) Priorität: **14.08.89 SU 4737599**

(43) Veröffentlichungstag der Anmeldung:
**20.02.91 Patentblatt 91/08**

(84) Benannte Vertragsstaaten:
**AT BE CH DE FR GB IT LI NL SE**

(71) Anmelder: **TSENTR NAUCHNO-TEKHNICHESKOGO TVORCHESTVA MOLODEZHI " LINAX"**
**Ulitsa Marshala Govorova, 34**
**Leningrad(SU)**

(72) Erfinder: **Lomashevich, Svyatoslav Alexandrovich**
**Ulitsa Zavodskaya 24, kv. 7**
**Leningrad(SU)**
Erfinder: **Eskin, Konstantin Fedorovich**
**Tikhoretsky prospekt 35, kv.152**
**Leningrad(SU)**
Erfinder: **Bystrov, Jury Lvovich**
**Prospekt 30-letia Pobedy, 30, kv.160**
**Penza(SU)**
Erfinder: **Semenova, Galina Alexandrovna**
**Ulitsa Turku 9, korpus 5, kv.201**
**Leningrad(SU)**

(74) Vertreter: **Sparing Röhl Henseler**
**Patentanwälte European Patent Attorneys**
**Rethelstrasse 123**
**D-4000 Düsseldorf 1(DE)**

(54) **Halbleiterlaserverstärker für optische Signale mit steuerbaren Spiegeln.**

(57) Das Ziel der Erfindung besteht darin, eine aktive Mehrzweckvorrichtung mit der Charakteristik der Differentialverstärkung zu schaffen, die es gestattet, optische Signale zu verstärken, mit der Änderung der Frequenz weiterzuleiten, zu formieren, zu generieren.

Die obengenannten Eigenschaften werden durch antireflektierende Schichten (2) auf den Spiegeln (5, 6) realisiert, die einen Phasenübergang der ersten Gattung im Bereich von Arbeitswellen und Temperaturen des Verstärkers aufweisen, welcher durch eine äußere und innere optische Änderung oder mit einem äußeren elektrischen Signal gesteuert wird.

FIG. 1

Die vorliegende Erfindung betrifft einen Halbleiterlaserverstärker für optische Signale mit steuerbaren Spiegeln.

Bekannt ist eine Vorrichtung (Marshall 1. et al. "Gain Characteristics of 1,5 $\mu$m nonlinear split contact laser amplifier" App. Phys. Lett., 53, N, 17, 1577 (1988)), die aus zwei Lasersektionen besteht, welche elektrisch geteilt, aber optisch miteinander verbunden sind. Eine nichtlineare Übertragungsfunktion der Vorrichtung mit einem Absorptionsbereich gestattet es im Prinzip, den Betrieb einer bistabilen optischen Verstärkung bei Injektionsströmen oberhalb der Grenze der Lasergenerierung zu realisieren, aber die Größe der Durchlaßfähigkeit ist wegen Absorptionserscheinungen, welche den Betrieb der optischen Bistabilität bestimmen, begrenzt (zeitweise 4 ns).

Von den bekannten Vorrichtungen steht der vorliegenden Anmeldung dem technischen wesen nach die Vorrichtung besonders nah, die in (El. Lett., 21, N 1, 33, (1985), Westlake H., O'Mahony M. "Gain characteristics of at 1.5 DCPBH in CaAsP Resonant Optical Amplifier") beschrieben ist. Diese Vorrichtung stellt einen Fabry-Perot-Resonanzverstärker dar, der praktisch einen Laser, welcher im Betrieb einer spontanen Emission arbeitet, darstellte. Durch das Auftragen von antireflektierenden Viertelwellenbeschichtungen (beispielsweise $SiO_x$) auf Spiegel solch eines Lasers ist es möglich, den Resonanzverstärker in einen Wanderwellenverstärker zu überführen. Da es praktisch unmöglich ist, die Spiegelreflexion völlig zu beseitigen, entstehen durch die Reflexion bedingte Effekte, die für Wanderwellenverstärker unerwünscht sind.

Der Verstärkungsfaktor des Fabry-Perot-Resonanzverstärkers sieht in Abhängigkeit von der Frequenz $\omega$ des Eingangssignals und der $\omega_p$-Resonanzfrequenz folgendermaßen aus:

$$G\phi_n = \frac{(1 - R_1)(1 - R_2)G_0}{(1 - \sqrt{R_1 R_2} \cdot G_0)^2 + 4\sqrt{R_1 R_2} \cdot G_0 \sin^2((\omega - \omega_p)L/v_g)} \qquad (1)$$

worin

$$G_0 = e^{(\Gamma_g - \alpha)L} \qquad (1'),$$

die innere Verstärkung der aktiven Schicht bei einem Durchgang,
$\Gamma_g$ der Faktor der Modebegrenzung,
$v_g$ die Geschwindigkeit des Signals,
L die Länge des Verstärkers und
$R_1$, $R_2$ Spiegelreflexionskoeffizienten bedeuten.

Die Kennlinie der Abhängigkeit (1) weist ein starkes Maximum im Bereich der Eigenresonanzfrequenzen des Fabry-Perot-Interferometers auf, dessen Schärfe durch die Spiegelreflexionskoeffizienten $R_1$ und $R_2$ bestimmt wird. Beim Übergang $\sqrt{R_1 R_2} \cdot G_0 \rightarrow 0$ geht der Resonanzverstärker in einen Wanderwellenverstärker über.

Die starke Frequenzabhängigkeit $G\phi_n$ ist nachteilig, weil diese solch eine Koinzidenz von $\omega$ und $\omega_p$ erfordert, daß bei der Abweichung der Frequenz praktisch nicht mehr als 40 GHz realisiert werden können.

Der zweite wichtige Nachteil der Resonanzverstärker besteht darin, daß das Sättigungsniveau des Ausgangssignals von -7 dBm bis -12 dBm (im Vergleich zu 10 dBm für Wanderwellenverstärker) beträgt.

Andererseits gestattet es ein zügiger Übergang $\sqrt{R_1 R_2} \cdot G_0 \rightarrow 0$, ohne die Halbleiterstruktur, die Pumphöhe zu ändern, zum Verstärker der optischen Signale überzugehen, welcher ein breites Frequenzband der Eingangssignale und eine hohe Ausgangssättigungshöhe aufweist.

Wenn man antireflektierende Schichten aufdampft, ist es möglich, einen Resonanzverstärker in einen Wanderwellenverstärker mit einem Reflexionskoeffizient von $10^{-4}$ umzuwandeln. Diese Umwandlung ist aber irreversibel, d.h., daß durch diese Änderung der Spiegelparameter die Vorrichtung ohne Rückkopplung verbleibt, welche diese Spiegel realisieren.

Der vorliegenden Erfindung liegt die Aufgabe zugrunde, einen Resonanzverstärker zu entwickeln, welcher im Betriebsverhalten der Injektionssynchronisation mit einer erhöhten Empfindlichkeit, mit einem breiten Frequenzband der Eingangssignale, der verkleinerten Spektralbreite und Rauschhöhe der Ausgangssignale arbeitet; das heißt, daß das Ziel der Erfindung darin besteht, einen Halbleiterlaserverstärker zu schaffen, der die Nachteile, die Verstärkern verschiedener Typen eigen sind, nicht aufweist, aber die Vorteile der Wanderwellenverstärker und der Injektionssynchronisierung behält.

Die Aufgabe wird dadurch gelöst, daß die antireflektierenden Schichten an einem oder beiden Spiegeln eine oder mehrere Schichten enthalten, die einen Phasenübergang der ersten Art im Bereich der Arbeitswellenlängen und der Verstärkertemperaturen aufweisen und durch äußere oder innere optische Strahlung oder mit einem elektrischen Signal gesteuert werden, wobei auf die antireflektierenden Schichten für die optische Strahlung durchsichtige oder ein "Fenster" enthaltende metallische Steuerelektroden aufgetragen sind, während für die Koeffizienten der Spiegelreflexion folgende Verhältnisse bestehen:

$R_{10} < R_{20} < R_{1t}, R_{20} < R_{2t}$ ,

worin $R_{10}$ und $R_{20}$ die Reflexionskoeffizienten des Eingangs- und Ausgangsspiegels vor dem Phasenübergang, $R_{1t}$ und $R_{2t}$ die Reflexionskoeffizienten nach dem Phasenübergang sind.

Der Einsatz von optischen dünnschichtigen Schichten mit einem Phasenübergang ist bekannt, aber bisher war deren Einsatz mit den Prozessen der Aufnahme einer optischen Information verbunden. In diesem Fall werden sie als Reversiermedium angewendet.

Somit kann man feststellen, daß das Vorhandensein einer oder zweier Schichten mit einem Brechungsindex, der sich unter Einwirkung des Lichtes sprunghaft ändert, neue Eigenschaften liefert, die sich von den Eigenschaften des bekannten, vorstehend erwähnten Verstärkers und analoger Verstärker unterscheiden, und zwar:

1. Erhöhung der Empfindlichkeit zum Eingangssignal. Dies ist dadurch bedingt, daß beim ersten Durchgang in der aktiven Zone die Verstärkung der Eingangssignale auf eine solche Intensitätsgröße verstärkt wird, bei welcher der Ausgangsspiegel und dann auch der Eingangsspiegel (beim Rückgang des Signals) wegen einer starken Erhöhung des Brechungsindexes der Beschichtungen eingeschaltet werden.

2. Fehlen der Sättigung des Verstärkungsfaktors, die für Wanderwellen-und Resonanzverstärker typisch ist. Dies erweist sich als möglich wegen eines plötzlichen Übergangs in den Betrieb der Lasergeneration von einem beliebigen Eingangssignal, der eine gewisse Grenzgröße, die bei der Anfangsregelung eingestellt wird, überschreitet.

3. Fehlen einer scharfen Empfindlichkeit gegenüber der Frequenz des Eingangssignals (und als Folge ist die Unnötigkeit einer genauen Einstellung zu verzeichnen), weil beim Einführen eines Signals in den optischen Verstärker die Spiegelreflexionskoeffizienten zu einem Minimum zurückgeführt sind (mittels mehrschichtiger Phasenschichten) und der Resonator nicht funktioniert.

4. Fehlen von strengen Anforderungen an die Stabilität der Größe des Injektionsstroms, der $I = 0,95 \cdot I_{Grenz.}$ ist (worin $I_{Grenz.}$ der Grenzwert des Stromes bei Lasergenerationsbetrieb ist), weil die Vorrichtung bei beliebiger Größe des Injektionsstromes ($I \geq I_{Grenz.}$) arbeitet.

5. Verringerung des Signal-Rausch-Verhältnisses wegen des Übergangs in den Lasergenerationsbetrieb und wegen der Verengung des Frequenzbandes beim Einschalten der Spiegel.

Nachstehend wird die Erfindung anhand eines in den beigefügten Abbildungen dargestellten Beispiels näher erläuterte.

Fig. 1 zeigt einen Halbleiterlaserverstärker mit steuerbaren Spiegeln.

Fig. 2 zeigt Resonanzkurven des Fabry-Perot-Interferometers, und zwar die untere Kurve beim Fehlen der Rückkopplung, die durch Spiegel realisiert wird, und die obere Kurve mit Rückkopplung.

Fig. 3 zeigt die Kennlinie der Laserdiode für zwei Betriebsarten, die sich voneinander durch den Reflexionsgrad der Spiegel in Übereinstimmung mit den Bezeichnungen der Fig. 2 unterscheiden.

Fig. 4 zeigt Hysteresekennlinien der optischen Bistabilität in der Laserdiode für verschiedene ursprüngliche Phasenverstimmungen des $\Delta\phi_1$, $\Delta\phi_2$-Interferometers.

Fig. 5 zeigt eine Charakteristik der Differenzverstärkung, die im Halbleiterlaserverstärker wegen des Effektes der optischen Bistabilität realisiert wird, $I_o$ bedeutet die Höhe der Pumpleistung des bistabilen Betriebs.

Fig. 6 zeigt eine Variante der elektrischen Steuerung der Spiegel.

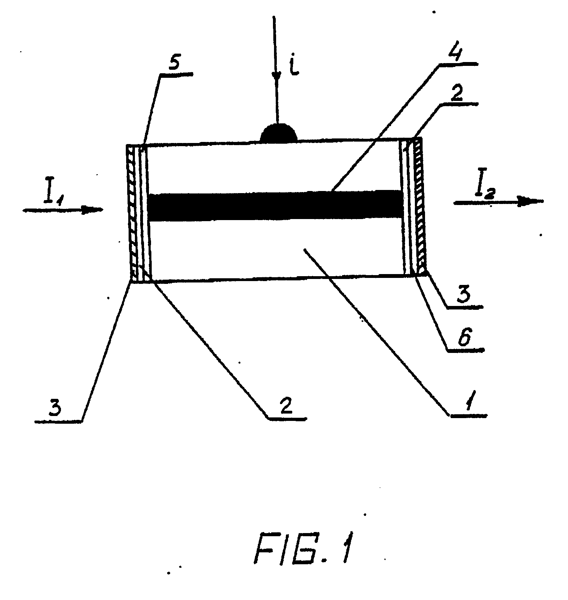

Der Halbleiterlaserverstärker für optische Signale mit steuerbaren Spiegeln (Fig. 1) enthält eine Laserheterostruktur 1, steuerbare Spiegel 5, 6, einen mehrschichtigen antireflektierenden Überzug 2, Steuerelektroden 3, die für die optische Strahlung durchsichtig sind, sowie eine aktive Schicht 4.

Der Verstärker arbeitet folgendermaßen:

Im Betrieb einer äußeren Steuerung der Spiegel 5, 6 ist die antireflektierende Schicht 2 nur auf den Eingangsspiegel 5 aufgetragen. Das ist keine in bezug auf den Eingang und den Ausgang gegenseitige Varianten. Mit anderen Worten bedeutet das ein Betriebsverhalten des äußeren Formierens des Ausgangsimpulses.

Beim Fehlen des Eingangssignals ist der Koeffizient der Reflexion des Eingangsspiegels $R_1 < < R_2$, der Injektionsstrom liegt im Bereich der Superluminiszenz der Diode, die Strahlung ist spontan.

Beim Auftreffen des Eingangssignals und dessen Einwirkung auf die steuerbare Schicht der Beschichtung 2 des Spiegels 5 erfolgt ein Phasenübergang unter Änderung der optischen Kennlinien der Beschichtung 2, was zum Verlassen der Bedingung der Phasenabstimmung der reflektierten Wellen durch die antireflektierende Beschichtung 2 und zu einem scharfen (mehr als 5 Größenordnungen) Anstieg des Reflexionskoeffizienten $R_1$ führte. Dabei ist $R_{1t} >> R_2$. Sprungartig ändert sich die Resonatorgüte des Lasers, was der Senkung des Grenzstromes entspricht, die Rückkopplung, die durch die Spiegel 5, 6 realisiert wird, schaltet sich ein, und die Vorrichtung geht in den Betrieb einer Lasergeneration über.

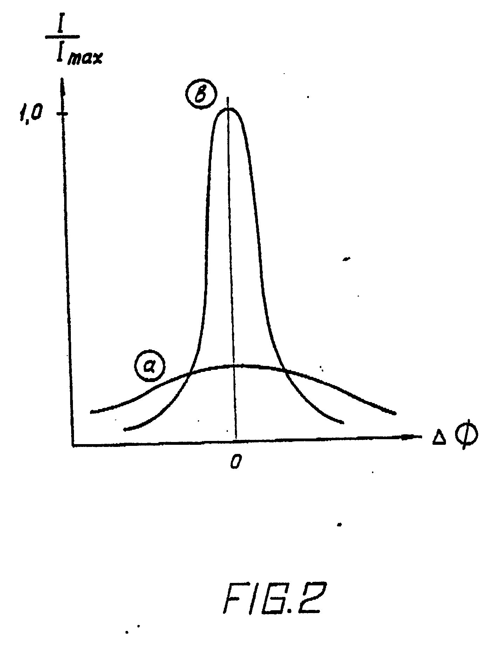

Fig. 2 zeigt Resonanzkurven des Halbleiterlaserverstärkers, und zwar die Abhängigkeit $I/I_{max}$ von der Verstimmung $\Delta\phi$ vor (Kurve a) und nach dem Phasenübergang in der antireflektierenden Beschichtung 2 (Kurve b).

Die Bedingung $R_{1t} >> R_2$ stellt eine Bedingung der "Nichtempfindlichkeit" zur inneren Strahlung dar, d.h. eine Bedingung der Steuerung des Phasenübergangs am Eingangsspiegel nur von einer Außenquelle (die Rückkopplung schaltet sich nur mit einem äußeren Signal ein).

Aus diesem Grund erfolgt das Einschalten der Vorrichtung sofort nach Beendigung der Wirkung des Eingangsimpulses, dh der Verringerung des Koeffizienten $R_t$ bis auf die Größe $R_1$, der Verstimmung des Resonators und der Ablösung der Lasergeneration. Dieser Zustand bleibt erhalten, bis das nächste optische Signal kommt.

Bei ungenügender Größe der Leistung des Eingangssignals kann die Steuerung des Eingangsspiegels 5 mittels Spannung über die metallische Steuerelektrode 3 erfolgen. In diesem Fall sind die elektrischen Impulse modulierend gegenüber dem optischen Impuls, der an den Eingang gelant; dementsprechend sind verschiedene Arbeitsvarianten möglich, und zwar der Verstärkung, Begrenzung, Regeneration, des Unterbrechens (nach der Dauer) des Eingangssignals in Abhängigkeit von der Form und der Dauer der elektrischen Impulse.

II. Betrieb mit innerer Steuerung der Spiegel 5, 6. Die antireflektierende Beschichtung 2 ist auf beide Spiegel 5, 6 aufgetragen. In diesem Fall wird eine gegenseitige, symmetrische Variante geprüft, d.h. der Betrieb eines inneren Formierens des Ausgangsimpulses oder der Verstärkung des optischen Signals in Übereinstimmung mit der Charakteristik des Differenzverstärkers.

Der Verstärker mit den auf die Spiegel 5, 6 aufgetragenen Beschichtungen 2, die im normalen Zustand die Reflexionskoeffizienten R von $10^{-4}$ bis $10^{-5}$ aufweisen, befindet sich in dem Betrieb, der einem Wanderwellenverstärker entspricht (d.h. er weist einen Verstärkungskoeffizienten von 30 dB bei einmaligem Durchgang auf). Die Injektionshöhe des Stromes wird entsprechend oder höher als der Grenzbetrieb gewählt (bei natürlichen Spiegeln mit einer Halbleiterstruktur ohne antireflektierende Schichten).

Das verstärkte Eingangssignal 1 kommt bis zum Ausgangsspiegel 6, unter Einwirkung des Lichtes passiert der Phasenübergang der mehrschichtigen Beschichtung 2, der Brechungsindex wächst stark an (bis auf die Größe von 0,3 -0,4), die optische Welle wird zum Eingangsspiegel 5 zurückreflektiert, die Intensität steigt an, dank des Phasenübergangs schaltet sich der Eingangsspiegel 5 ein - das Licht wird in zwei Übergängen (hin und zurück) im Fabry-Perot-Interferometer "geschlossen".

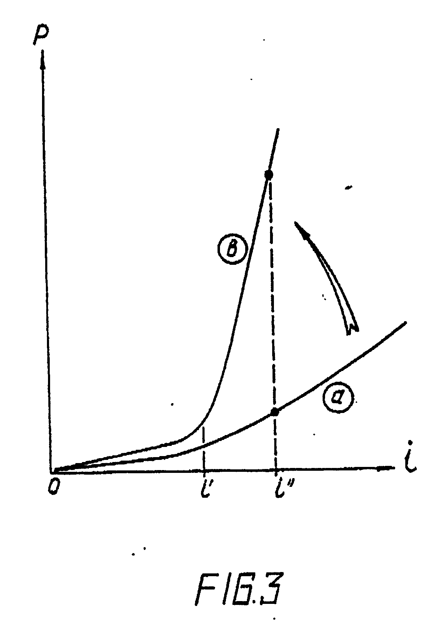

Fig. 3 stellt die Abhängigkeit der optischen Leistung P vom Injektionsstrom i dar. Da der Injektionsstrom i höher oder gleich dem Grenzwert des Stromes $i'$ ist ($i \geq i'$), wird die Vorrichtung der Laserwirkung unterworfen (Fig. 3), es steigt stark die Interresonanzlichtintensität, die Nichtlinearerscheinungen in der aktiven Zone provoziert; der Verstärker geht zugleich in den Betrieb des Resonanzverstärkers über, genauer gesagt in den eines Verstärkers mit Injektionssynchronisierung.

Wie bekannt, kann der Laserverstärker als nichtlineares Fabry-Perot-Interferometer wirken und Eigenschaften der Bistabilität zeigen. Dies wird wegen relativ starker Abhängigkeit des Brechungsindexes n von der Elektronenkonzentration und Dichte des Lichtfeldes möglich.

Die Sättigung des summaren optischen Verstärkungsfaktors g in Abhängigkeit von der inneren Intensität $g_0$ im aktiven Bereich des Verstärkers kann folgendermaßen ausgedrückt werden:

$$g = \frac{g_0}{1 + \dfrac{I}{I_s}} - \alpha \quad (2),$$

worin $I_s$ den ungesättigten Verstärkungsfaktor und $\alpha$ Verluste, bedingt durch die Absorption und Streuung, bedeuten.

Der Beitrag der nichtlinearen Brechung läßt sich durch die Änderung der Phasenanströmung im Resonanzraum bei einem Übergang

$$\phi \quad \phi_o \ (\frac{G_o L_b}{2}) \ \frac{I/I_s}{1 + I/I_s} \quad (3)$$

auswerten,

worin $L_b$ die Resonatorlänge,

$\phi_o$ die Größe der Anfangsverstimmung

$$I_s = \frac{h\nu}{r\tau dgm/\alpha h} ,$$

r den Begrenzungsfaktor und

$\tau$ die Rekombinationszeit

bedeuten.

Die Größenordnung beträgt

$$I_s : 10^6 \ \frac{W}{cm^2} .$$

Eine minimale Änderung $\Delta_n$ im Brechungsindex, die für die Beobachtung der Umschaltung erforderlich ist, wird nach der Änderung von $\Delta_n$ bewertet, die in der Phasenverschiebung beim Ringdurchgang der Lichtwelle des Resonanzraumes bei der Gleichheit dieser Phasenverschiebung der Breite der Resonanzkurve (1) entsteht, und zwar $\sim \frac{\pi}{F}$ (worin F die Güte des Resonators bedeutet): $\Delta\phi = \frac{2\pi}{\lambda} \ \Delta_n L \approx \frac{\pi}{2F}$ .

Bei nichtlinearer Abhängigkeit des Brechungsindex $n = n_o + n_2^j$ gilt folgende Gleichung: $\Delta\phi = \frac{2\pi}{\lambda} \cdot n_2 I L$

Die Qualität des Resonators wird unter Berücksichtigung von (1´) nach der Formel errechnet:

$$F = \frac{(G_o \cdot R)^{1/2}}{1 - G_o R},$$

wobei $R1_1 = R_2 = R$ ist, und stellt einen wichtigen Faktor dar, der von R zum Formieren eines bistabilen Betriebs im Verstärker abhängt. Es steht fest, daß die Änderung $\Delta_n = 10$, die zur Umschaltung in den Verstärkern erforderlich ist, sich um zwei Ordnungen kleiner als in passiven bistabilen Zellen erweist, die Umschaltungsleistungen bis auf die Größen von etwa $10^{-15}$J in mkW/Energie bei Umschaltungszeiten von 0,5 ns fallen.

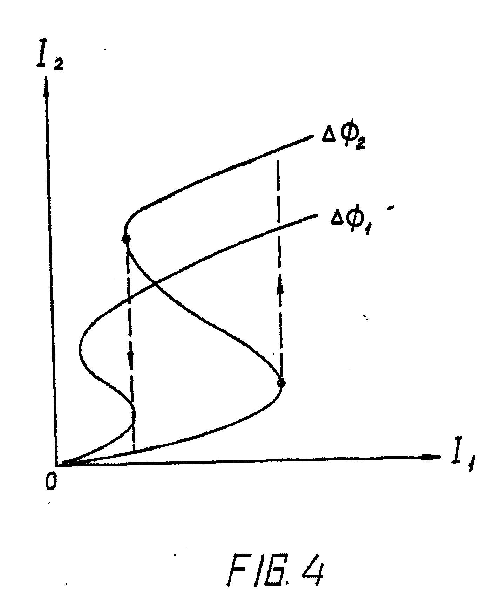

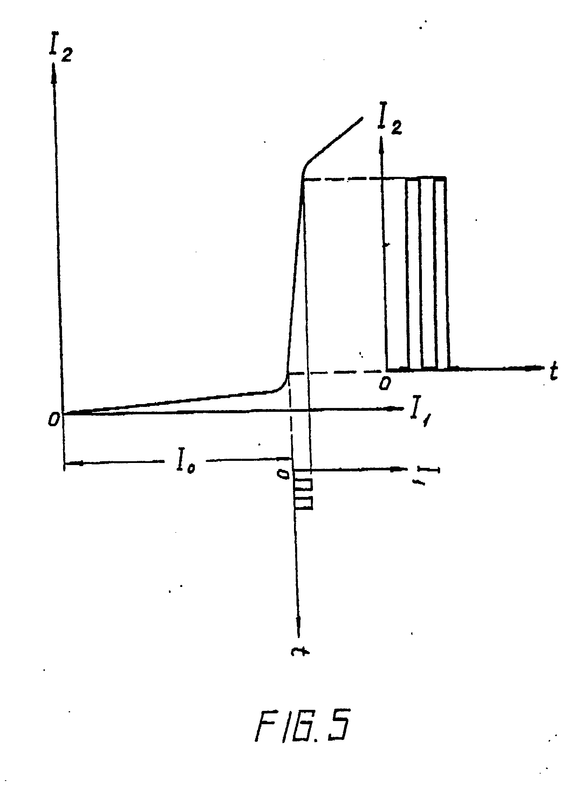

Als Lösung der Gleichungen (1), (2) und (3) gelten die Charakteristiken, die in Fig. 4 dargestellt sind und die Abhängigkeit des Ausgangssignals $I_2$ vom Eingangssignal $I_1$ bei unterschiedlichen Verstimmungen von $\Delta\phi_2$ und $\Delta\phi_1$ zeigen.

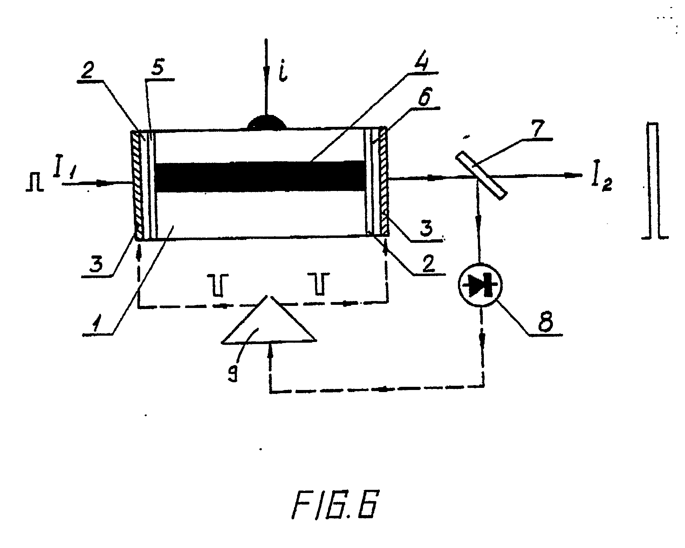

Die Einschaltung der Spiegel bei der Höhe des Injektionsstromes höher als der Grenzwert gestattet es, nicht nur einen Verstärker für optische Signale, der im Betriebsverhalten der Injektionssynchronisierung mit den zur Zeit bekannten höchsten Verstärkungsfaktoren (bis 40 dB) arbeitet, sondern auch eine bestabile Charakteristik, d.h. bei der entsprechenden Anfangsverstimmung des Resonators die Kurve der Differentialverstärkung (s. Fig. 5), zu realisieren.

Die Ausschaltung erfolgt durch den elektronischen Stromkreis, der in Fig. 6 dargestellt ist. Ein Teil der optischen Leistung verzweigt sich` mittels eines Spiegels 7 (oder durch einen Richtungskoppler bei der Übertragung der Information durch den optischen Leiter), kommt auf einen Fotoempfänger 8, der Fotostrom weiter auf einen Elektronenvervielfacher 9 und mit negativer Polarität auf die Elektroden der antireflektierenden Phasenschichten. Der Spannungsimpuls bringt die antireflektierenden Schichten 2 in die Anfangsstellung zurück, indem er dabei den Spiegelreflexionskoeffizienten wesentlich verringert. Die Lasergeneration bricht ab.

Im Verstärker werden die Dauer, Amplitude und Verzögerungszeit der elektrischen Impulse, die für jedes optische Signal erzeugt werden, formiert. Dies kann als eine zusätzliche Möglichkeit für die Überwachung der Parameter des Halbleiterlaserverstärkers angesehen werden.

Das bevorzugte Anwendungsgebiet der anmeldungsgemäßen Vorrichtung sind Lichtleitersysteme zur Verbindung und Übertragung der Information, Schaltungen der Integraloptik und der Rechentechnik.

**Ansprüche**

1. Halbleiterlaserverstärker für optische Signale mit steuerbaren Spiegeln (5, 6), bestehend aus der Laserstruktur mit Eingangs- und Ausgangsspiegeln und Elementen der Strahlungsein- und -abführung, dadurch **gekennzeichnet,** daß antireflektierende Beschichtungen (2) an einem oder beiden Spiegeln (5, 6) eine oder mehrere Schichten enthalten, die einen Phasenübergang erster Gattung im Bereich der Arbeitswellenlängen und der Verstärkertemperaturen aufweisen oder durch eine äußere oder innere optische Strahlung oder von einem äußeren elektrischen Signal gesteuert werden.

2. Halbleiterlaserverstärker nach Anspruch 1, dadurch gekennzeichnet, daß für die Reflexionskoeffizienten der Spiegel (5, 6) folgende Verhältnisse $R_{10} < R_{20} < R_{1t}$ ; $R_{20} < R_{2t}$ , vorliegen, worin $R_{10}$ und $R_{20}$ Reflexionskoeffizienten des Eingangs- und Ausgangsspiegels vor dem Phasenübergang, $R_{1t}$ und $R_{2t}$ Reflexionskoeffizienten nach dem Phasenübergang bedeuten.

FIG. 1

FIG.2

FIG.3

FIG. 4

FIG.5

FIG.6